# EUROPÄISCHE PATENTSCHRIFT

(11) **EP 3 625 806 B1**
(45) Veröffentlichungstag und Bekanntmachung des Hinweises auf die Patenterteilung: **31.07.2024**
(21) Anmeldenummer: 18729577.9
(22) Anmeldetag: 15.05.2018
(51) Int. Cl.: H01C 1/144, H05K 1/16, H05K 3/40, H01C 7/00, H01C 1/012, H01C 1/084, H01C 3/12

(54) **LEISTUNGSWIDERSTAND**
POWER RESISTOR
RÉSISTANCE DE PUISSANCE

(30) Priorität: 15.05.2017 EP 17171188
(43) Veröffentlichungstag der Anmeldung: 25.03.2020
(73) Patentinhaber: EBG Elektronische Bauelemente GmbH, 4663 Laakirchen (AT)
(72) Erfinder: LINDNER, Christian Rene, 8341 Paldau (AT); PRASCHK, Josef, 8082 Kirchbach in der Steiermark (AT)
(74) Vertreter: Jell, Friedrich
(86) Internationale Anmeldenummer: PCT/EP2018/062630
(87) Internationale Veröffentlichungsnummer: WO 2018/210888

(56) Entgegenhaltungen:
- EP-A1- 0 963 143
- EP-A1- 3 093 856
- DE-A1- 2 347 049
- DE-U1- 9 217 269
- FR-A1- 2 713 396
- JP-A- 2005 032 912
- JP-A- 2016 139 732
- JP-A- H02 238 601
- US-A- 4 183 136
- US-A- 5 451 174

## Beschreibung

### Technisches Gebiet

Die Erfindung betrifft einen Leistungswiderstand mit mindestens einem elektrischen Anschluss, mit einem Trägersubstrat, das mindestens ein Widerstandselement aus einem Dickschichtmaterial und mindestens eine Kontaktelektrode aufweist, an die das Widerstandselement elektrisch anschließt, mit wenigstens einem elektrischen Leiter, der mit der Kontaktelektrode verlötet ist und eine elektrische Verbindung zwischen der Kontaktelektrode und dem elektrischen Anschluss herstellt, und mit einem, zumindest teilweise mit mindestens einer Vergussmasse gefüllten Gehäuse, das Widerstandselement und Kontaktelektrode vergossen aufnimmt, wobei der elektrische Leiter durch die Vergussmasse ragt.

### Stand der Technik

Um zwischen den Anschlüssen eines Leistungswiderstands und dem Widerstandselement auf einem keramischen Trägersubstrat im vergossenen Gehäuse des Hochleistungswiderstands eine elektrische Verbindung herzustellen, ist es bekannt (DE3715860A1), flexible elektrische Leiter vorzusehen. Diese Leiter sind je einerends mit einer Elektrode des Schichtwiderstands verlötet und anderends an einen elektrischen Anschluss befestigt, welcher in der Art eines Kabelschuhs ausgeführt ist. Nachteilig bedarf es für eine derartige elektrische Verbindung eines vergleichsweise hohen Herstellungsaufwands.

Zudem bedürfen derart ausgeführte Steck-Anschlüsse einer standfesten mechanischen Anbindung an das Gehäuse bzw. damit aufwendiger mechanischer Sicherungsmaßnahmen, um sowohl Montagekräften beim elektrischen Anschluss des Leistungswiderstands als auch einer Wärmedehnung standzuhalten, den elektrischen Kontakt mit dem elektrischen Leiter sicherzustellen.

Aus der US 3 093 856 A1 sind die Merkmale des Oberbegriffs bekannt. Nachteilig bedarf es zwischen elektrischen Leiter und Kontaktelektrode eines Bonddrahts, was zu einem erhöhten Konstruktionsaufwand am Leistungswiderstand führt und auch die Standfestigkeit des Leistungswiderstands, vergleichsweise hohe elektrische Leistungen aufzunehmen, beeinträchtigen kann. Weitere relevante Dokumente sind EP3093856A1, EP0963143A1 und US4183136A.

### Darstellung der Erfindung

Die Erfindung hat sich daher die Aufgabe gestellt, einen Leistungswiderstand der eingangs geschilderten Art derart zu verändern, dass bei konstruktiver Einfachheit erhöhte Standfestigkeit am Leistungswiderstand erreichbar ist.

Die Erfindung löst die gestellte Aufgabe dadurch, dass ein Stift, insbesondere ein Löt- oder Einpressstift, den elektrischen Leiter ausbildet, welcher Stift auf die Kontaktelektrode aufgesetzt und mit dieser verlötet ist sowie den elektrischen Anschluss des Leistungswiderstands ausbildet.

Eine deutliche konstruktive Vereinfachung in der elektrischen Verbindung der Elektrode auf dem Trägersubstrat mit dem Anschluss am Leistungswiderstand kann sich ergeben, wenn ein Stift, insbesondere ein Löt- oder Einpressstift, den elektrischen Leiter ausbildet, welcher Stift auf die Kontaktelektrode aufgesetzt und mit dieser verlötet ist sowie den elektrischen Anschluss des Leistungswiderstands ausbildet. Erfindungsgemäß dient damit der elektrische Leiter auch als elektrischer Anschluss am Leistungswiderstand - womit sich zur elektrischen Verbindung zwischen Elektrode und Anschluss eine aus dem Stand der Technik bekannte, feste elektrische Kontaktstelle zwischen Leiter und Anschluss erübrigt. Dies kann die Gefahr eines Leitungsbruchs an vorgenannter Kontaktstelle ausschließen - und so zur Erhöhung der Standfestigkeit am Leistungswiderstand beitragen, zumal auch Wärmedehnungseffekte vom Stift aufgenommen und vom Leistungswiderstand abgetragen werden können.

Jene auf den Anschluss wirkenden mechanischen Belastungen können in weiterer Folge durch die auf der Elektrode aufgesetzten Verlötung des Stifts ohne Weiteres vom Trägersubstrat aufgenommen und damit abgetragen werden, ohne dass mit einem Leitungsbruch in der elektrischen Verbindung zwischen Kontaktelektrode und Anschluss gerechnet werden muss. Außerdem kann die Vergussmasse, durch die der Stift ragt, zur mechanischen Stabilität des Anschlusses zusätzlich beitragen.

Die konstruktive Vereinfachung des Leistungswiderstands durch Zuhilfenahme eines Stifts kann daher auch die Standfestigkeit am Leistungswiderstand weiter erhöhen. Ein standfester, einfach handzuhabender und anschlusssicherer Leistungswiderstand kann sohin geschaffen werden.

Letzteres kann weiter verbessert werden, wenn der Stift als Einpressstift ausgebildet ist und damit am Anschluss des Widerstandelements eine elektrische Verbindung mit Kraftschluss herstellbar ist.

Weist der Stift an seinem ersten Ende eine ebene Stirnfläche auf, welche auf der Kontaktelektrode aufgesetzt und mit dieser verlötet ist, kann der feste elektrische Kontakt hinsichtlich seiner elektrischen und mechanischen Eigenschaften weiter verbessert werden. Damit können unter anderem Kerbwirkungen zwischen Einpressstift und Elektrode sowohl beim stoffschlüssigen Verlöten als auch bei mechanischen Belastungen vermieden werden, was die Gefahr einer punktuellen Schwächung des festen elektrischen Kontakts vermindert.

Der elektrische und mechanische Kontakt zwischen Elektrode und Einpressstift kann vergrößert werden, wenn der Einpressstift an seinem ersten Ende einen auskragenden Montagekopf aufweist. Dieser Montagekopf kann in Form eines Fußes, was beispielsweise zu eine L-förmigen Einpressstift führt, oder umlaufend auskragend, was beispielsweise zu eine T-förmigen Einpressstift führt, ausgebildet sein.

Kragt der Montagekopf umlaufend aus, können etwa mechanische Belastungen richtungsunabhängig gleichmäßiger auf das Trägersubstrat abgetragen werden. Derart ist auch die Standfestigkeit des Leistungswiderstands weiter verbesserbar. Letzteres besonders dadurch, wenn der Montagekopf kreisrund umlaufend auskragt und damit mechanische Belastungen richtungsunabhängig aufgenommen werden können.

Alternativ zu einer umlaufenden Auskragung kann der Montagekopf mindestens einen Lötfuß aufweisen, damit er auf einer vergleichsweise schmalen Kontaktelektroden vorgesehbar ist. Weist der Stift zwei Lötfüße auf, kann dies von einer L-förmigen Ausbildung zu einer T-förmigen Ausbildung am Stift führen.

Konstruktiv einfach gelöst, kann die Kontaktfläche vergrößert werden, indem der auskragende Montagekopf die ebene Stirnfläche ausbildet.

Vorzugsweise sind auf dem Trägersubstrat mehrere Kontaktelektroden mit je mindestens einem angelöteten Stift vorgesehen sind, wobei an zwei Kontaktelektroden je ein Widerstandselement elektrisch anschließt. Damit werden für beide Anschlüsse des Widerstandselements dieselben erfindungsgemäßen Vorteile nutzbar.

Bildet der als Einpressstift ausgeführte Stift mit seinem Einpresskopf den elektrischen Anschluss aus, kann eine sichere Anschlussmöglichkeit am Leistungswiderstand geschaffen werden - welche außerdem die Montage des Leistungswiderstands erleichtern kann.

Steht der Einpresskopf dem Gehäuse vor, kann sich aufgrund des gegenüber dem Gehäuse frei zugänglichen elektrischen Anschlusses die Montage des Widerstandselements weiter erleichtern.

Vorzugsweise weist das Gehäuse eine offene Breitseite auf, um dieses als Gussform für die Vergussmasse nutzbar zu machen. Die Herstellung des Widerstandselements kann damit erleichtert und in seinen Kosten gesenkt werden.

Die Kühlung des Widerstandselements und in weiterer Folge Zuverlässigkeit und Standfestigkeit können verbessert werden, wenn das Trägersubstrat an einer zweiten Breitseite des Gehäuses vorgesehen ist - insbesondere, wenn das Trägersubstrat diese Breitseite des Gehäuses ausbildet.

Die Konstruktion des Widerstandselements kann weiter vereinfacht werden, wenn es an einem plattenförmigen Trägersubstrat aus einem keramikartigen Material vorgesehen ist.

Bevorzugt kann die Vergussmasse mehrschichtig sein, wovon ein erstes Schichtmaterial auf Silikonbasis das Widerstandselement vergießt und der Stift durch ein zweites Schichtmaterial auf Epoxidharzbasis ragt, um damit mechanische Festigkeit sowie elektrische Standfestigkeit am Leistungswiderstand zu optimieren.

Die elektrische und mechanische Verbindung des Stifts mit der Kontaktelektrode kann standfester ausgeführt werden, wenn das erste Schichtmaterial auf Silikonbasis den Montagekopf des Stifts vergießt.

Vorzugsweise ist das zweite Schichtmaterial auf dem ersten Schichtmaterial angeordnet, was die Konstruktion des Leistungswiderstands vereinfacht bzw. auch dessen Vergießen bzw. Herstellung erleichtert. Vorzugsweise ist das zweite Schichtmaterial auch an dem ersten Schichtmaterial angeordnet.

Im Allgemeinen wird erwähnt, dass das Widerstandselement ein Dickfilmwiderstand sein kann. Solch ein Widerstandselement kann beispielsweise durch Aufbringen von Ruthenium-basierten Widerstandspasten, Cermet, etc. auf das Trägersubstrat ausgebildet werden.

Im Allgemeinen wird weiter erwähnt, dass eine Kontaktelektrode zum elektrischen Anschluss eines Widerstandselements eine AgPd, AgPt-Dickfilmpaste, etc. aufweisen kann.

Zudem wird im Allgemeinen erwähnt, dass das elektrisch isolierende Trägersubstrat vorzugsweise plattenförmig ist. Dieses Trägersubstrat kann Keramik und/oder ein keramikartiges Material, vorzugsweise Aluminiumoxidkeramik, etc. aufweist oder daraus bestehen. Auch kann das Trägersubstrat ein Verbundwerkstoff mit einer Keramik und/oder einem keramikartigen Material sein, beispielsweise mit zwei äußeren Keramikplatten mit einer mittigen Metallplatte.

### Kurze Beschreibung der Zeichnungen

In den Figuren ist der Erfindungsgegenstand beispielsweise anhand einer Ausführungsvariante näher dargestellt. Es zeigen
- Fig. 1: eine Schnittansicht auf ein Widerstandselement,
- Fig. 2a, 2b: vergrößerte Teilansichten der Fig. 1 und

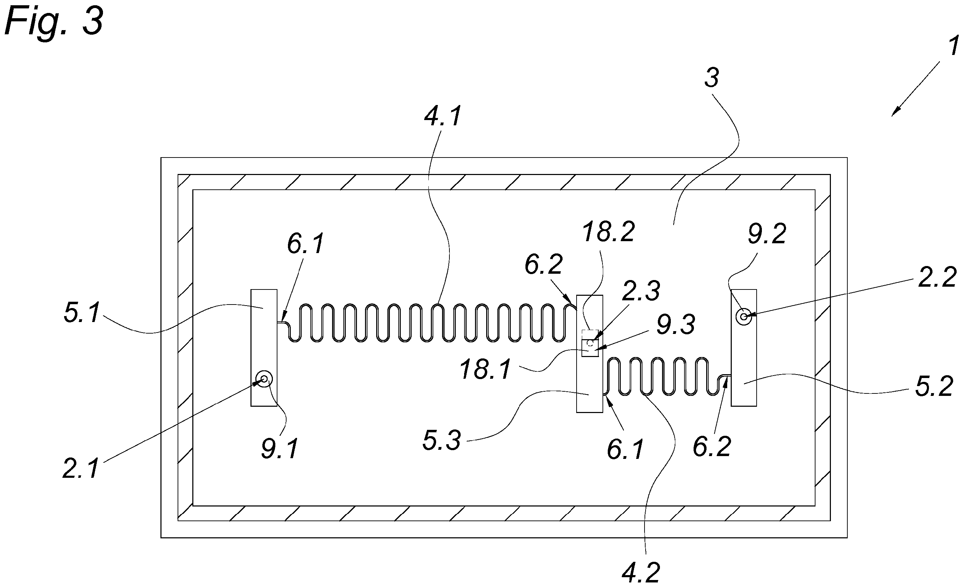

- Fig. 3: eine teilweise aufgerissene Draufsicht auf das nach Fig. 1 dargestellte Widerstandselement.

### Weg zur Ausführung der Erfindung

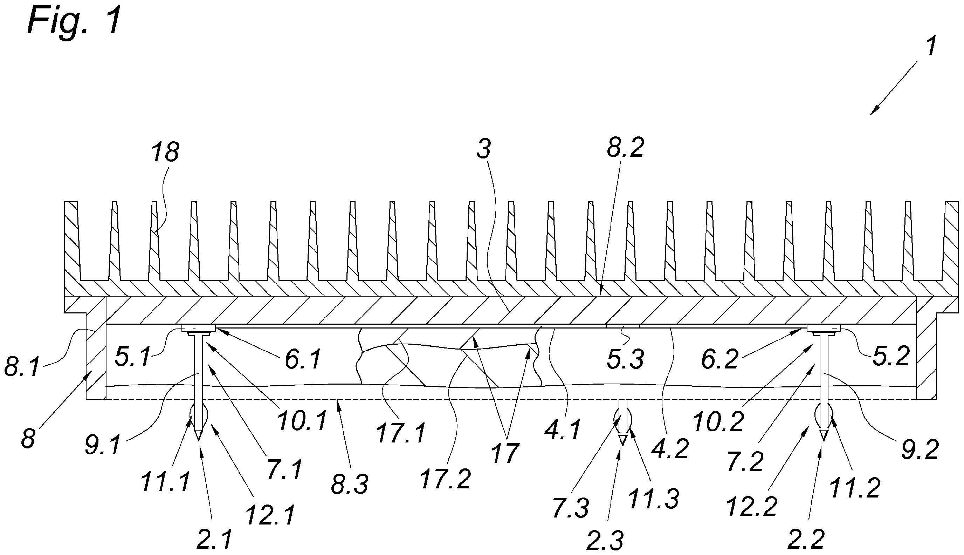

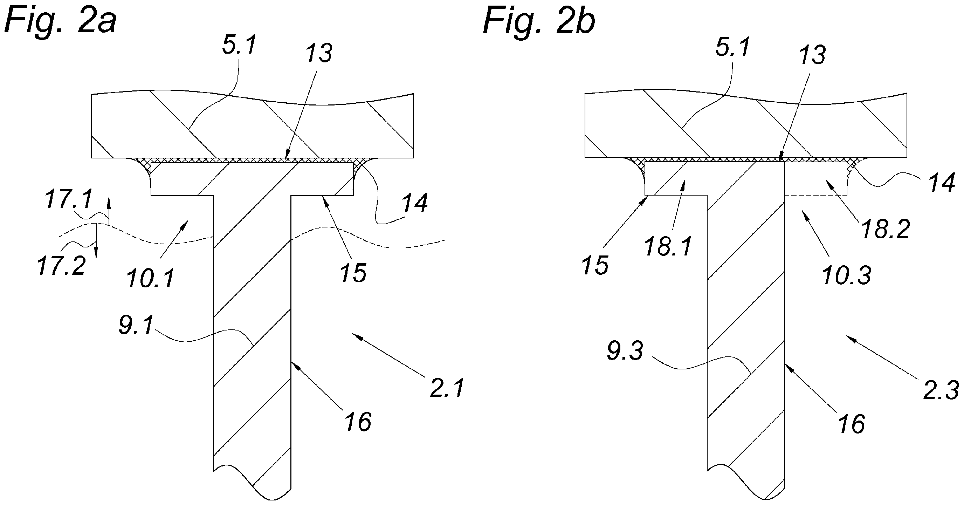

Der nach den Figuren 1, 2a und 2b beispielsweise dargestellte Leistungswiderstand 1 weist drei elektrische Anschlüsse 2.1, 2.2, 2.3 auf, welche den Hauptanschluss bzw. Leistungsanschluss des Leistungswiderstands 1 ausbilden. Im Allgemeinen ist aber auch vorstellbar, dass die elektrischen Anschlüsse 2.1, 2.2, 2.3 anderen Zwecken dienen - etwa zur Übertragung von Sensorsignalen aus dem Leistungswiderstand 1 etc., was jedoch nicht dargestellt ist.

Der Leistungswiderstand 1 weist zudem ein plattenförmiges Trägersubstrat 3 aus einem elektrisch isolierenden Material, beispielsweise keramikartigem Material, auf, was auch Aluminiumoxidkeramik sein kann. Das Trägersubstrat 3 kann ein oder mehrschichtig aufgebaut sein.

Auf dem Trägersubstrat 3 sind mehrere Widerstandselemente 4.1, 4.2 aus einem Dickschichtmaterial vorgesehen, die elektrisch in Serie geschaltet gemeinsam den Widerstand des Leistungswiderstands 1 ausbilden. Das Trägersubstrat 3 dient zudem als Wärmeleiter zur Kühlung der Widerstandselemente 4.1, 4.2.

Die beiden Widerstandselemente 4.1, 4.2 liegen elektrisch zwischen zwei Kontaktelektroden 5.1, 5.2, 5.3, die je an ein Ende 6.1 bzw. 6.2 der Widerstandselemente 4.1 bzw. 4.2 elektrisch anschließen. Zudem sind drei elektrische Leiter 7.1, 7.2, 7.3 vorgesehen, die mit der jeweiligen Kontaktelektrode 5.1, 5.2, 5.3 verlötet sind und je eine elektrische Verbindung zwischen der Kontaktelektrode 5.1 bzw. 5.2 bzw. 5.3 und den elektrischen Anschlüssen 2.1 bzw. 2.2 bzw. 2.3 herstellen.

Die Widerstandselemente 4.1, 4.2 und die Kontaktelektroden 5.1, 5.2, 5.3 werden von einem Gehäuse 8 aufgenommen und so gegenüber mechanischer Beschädigung geschützt.

Erfindungsgemäß werden die elektrischen Leiter 7.1, 7.2, 7.3 von je einem Stift 9.1, 9.2, 9.3, nämlich Einpressstift, ausgebildet. Die Stift 9.1, 9.2, 9.3 sind jeweils an ihrem ersten Ende 10.1, 10.2, 10.3 auf die jeweilige Kontaktelektrode 5.1, 5.2, 5.3 aufgesetzt und mit dieser verlötet, um eine mechanische und elektrische Verbindung auszubilden. Der Einpresskopf 11.1, 11.2, 11.3 des jeweiligen Stifts 9.1, 9.2, 9.3 am anderen zweiten Ende 11.1, 11.2, 11.3 bildet den elektrischen Anschluss 2.1, 2.2, 2.3 aus. Dadurch ist eine einfache konstruktive Lösung geschaffen, um eine standfeste elektrische Verbindung zwischen Kontaktelektrode 5.1, 5.2, 5.3 und Anschluss 2.1, 2.2, 2.3 zu ermöglichen. Es ist aber auch vorstellbar, dass der Stift 9.1, 9.2. 9.3 von einem Lötstift, also einem Stift ohne Einpresskopf, ausgebildet wird, was nicht näher dargestellt worden ist.

Wie nach Fig. 2a im Detail anhand des Stifts 9.1 zu erkennen, was beispielsweise für alle anderen Stifte 9.2 und 9.3 gilt, weisen dieser Stifts 9.1 am ersten Ende 10.1 je eine ebene Stirnfläche 13 auf. Diese ebenen Stirnflächen 13 der Stifte 9.1, 9.2, 9.3 sind auf die jeweilige Kontaktelektrode 5.1, 5.2, 5.3 aufgesetzt und mit dieser verlötet, wie dies am die Stirnfläche 13 umfassenden und überzeichnet dargestellten Lötkegel 14 erkennbar ist. Die ebenen Stirnflächen 13 befinden sich am jeweiligen Montagekopf 15 der Stifte 9.1, 9.2, 9.3.

Bei den beiden äußeren Stiften 9.1, 9.2 nach Fig. 2a kragt der Montagekopf 15 gegenüber dem Stiftbein 16 umlaufend kreisrund aus, wodurch sich die Stirnfläche 13 vergrößert. Dies führt zu einem mechanisch und elektrisch verbesserten festen Kontakt zwischen der Kontaktelektrode 5.1 bzw. 5.2 und dem jeweiligen Stift 9.1 bzw. 9.2 - womit die Standfestigkeit des Leistungswiderstands 1 erhöht wird.

Ähnlich ist dies auch beim mittleren Stift 9.3 nach Fig. 2b, dessen Montagekopf 15 jedoch anders ausgebildet ist. Hier kragt ein stegförmiger Lötfuß 18.1 aus, was zu einem L-förmigen Stift 9.3 führt und so selbst bei einer schmalen Kontaktelektrode 5.3 vorgesehen werden kann. Gleiches gilt im Falle, dass zwei diametral gegenüberliegende stegförmige Lötfüße 18.1, 18.2 vorgesehen sind, wie dies in Fig. 2 strichliert zu erkennen ist, und sich damit ein T-förmiger Stift 9.3 ausbildet.

Der Aufbau des Leistungswiderstands 1 ist vergleichsweise einfach gelöst, indem das Gehäuse 8 von einer geschlossenen Seitenwand 8.1 und dem Trägersubstrat 3, als einen Abschnitt der zweiten Breitseite 8.2 gebildet wird. Damit ist am Trägersubstrat 3 ein Kühlkörper 19 vorsehbar. Unter anderem kann damit der Leistungswiderstand 1 trotz Vergussmasse 17 besonders gut gekühlt werden.

Die erste Breitseite 8.3, beispielsweise der Boden des Gehäuses 8, ist offen und gibt die Sicht auf eine Vergussmasse 17 frei, welche - in das Gehäuse 8 eingefüllt - Widerstandselement 4.1, 4.2 und Kontaktelektrode 5.1, 5.2, 5.3 verkapselt.

Nach Fig. 1 und 2a ist zu sehen, dass die Vergussmasse 17 verschiedene, vorzugsweise aufeinander angeordnete Materialschichten aufweist und damit mehrschichtig ausgebildet ist. In Fig. 2a ist der Übergang zwischen den zwei Schichtmaterialien 17.1, 17.2 strichliert dargestellt. So sind das Widerstandselement 4.1, 4.2 und die Kontaktelektrode 5.1, 5.2, 5.3 im ersten Schichtmaterial 17.1 auf Silikonbasis oder aus einem Silikonwerkstoff vergossen. Auf dieses erste Schichtmaterial 17.1 ist das zweite Schichtmaterial 17.2 auf Epoxidharzbasis oder auf Polyurethanbasis oder dgl. vorgesehen. Das erste Schichtmaterial 17.1 kann das Widerstandselement 4.1, 4.2 und die Kontaktelektrode 5.1, 5.2, 5.3 elastisch verkapseln und die zweite Schicht der Festigkeit der Verkapselung erhöhen. Zudem vergießt auch das erste Schichtmaterial 17.1 auf Silikonbasis den Montagekopf 15 des Stifts 9.1, 9.2, 9.3.

Die Einpressstifte 9.1, 9.2 ragen durch diese Vergussmasse 17. Die Einpressköpfe 11.2, 11.2, 11.3 stehen dem Gehäuse 8 vor, wodurch der Leistungswiderstand 1 einfach montiert und elektrisch angeschlossen werden kann.

## Patentansprüche

1. Leistungswiderstand mit mindestens einem elektrischen Anschluss (2.1, 2.2, 2.3), mit einem Trägersubstrat (3), das mindestens ein Widerstandselement (4.1, 4.2) aus einem Dickschichtmaterial und mindestens eine Kontaktelektrode (5.1, 5.2, 5.3) aufweist, an die das Widerstandselement (4.1, 4.2) elektrisch anschließt, mit wenigstens einem elektrischen Leiter (7.1, 7.2, 7.3), der mit der Kontaktelektrode (5.1, 5.2, 5.3) verlötet ist und eine elektrische Verbindung zwischen der Kontaktelektrode (5.1, 5.2, 5.3) und dem elektrischen Anschluss (2.1, 2.2, 2.3) herstellt, und mit einem, zumindest teilweise mit mindestens einer Vergussmasse (17) gefüllten Gehäuse (8), das Widerstandselement (4.1, 4.2) und Kontaktelektrode (5.1, 5.2, 5.3) vergossen aufnimmt, wobei der elektrische Leiter (7.1, 7.2, 7.3) durch die Vergussmasse (17) ragt, **dadurch gekennzeichnet, dass** ein Stift, insbesondere ein Löt- oder Einpressstift, den elektrischen Leiter (7.1, 7.2, 7.3) ausbildet, welcher Stift (9.1, 9.2, 9.3) auf die Kontaktelektrode (5.1, 5.2, 5.3) aufgesetzt und mit dieser verlötet ist sowie den elektrischen Anschluss (2.1, 2.2, 2.3) des Leistungswiderstands (1) ausbildet.

2. Leistungswiderstand nach Anspruch 1, **dadurch gekennzeichnet, dass** der Stift (9.1, 9.2, 9.3) an seinem ersten Ende (10.1, 10.2, 10.3) eine ebene Stirnfläche (13) aufweist, welche auf der Kontaktelektrode (5.1, 5.2, 5.3) aufgesetzt und mit dieser verlötet ist.

3. Leistungswiderstand nach Anspruch 1 oder 2, **dadurch gekennzeichnet, dass** der Stift (9.1, 9.2, 9.3) an seinem ersten Ende (10.1, 10.2, 10.3) einen auskragenden Montagekopf (15) aufweist.

4. Leistungswiderstand nach Anspruch 3, **dadurch gekennzeichnet, dass** der Montagekopf (15), insbesondere kreisrund, umlaufend auskragt.

5. Leistungswiderstand nach Anspruch 3, **dadurch gekennzeichnet, dass** der Montagekopf (15) mindestens einen Lötfuß (18.1, 18.2) aufweist.

6. Leistungswiderstand nach Anspruch 3, 4 oder 5, **dadurch gekennzeichnet, dass** der Montagekopf (15) eine ebene Stirnfläche (13) ausbildet.

7. Leistungswiderstand nach einem der Ansprüche 1 bis 6, **dadurch gekennzeichnet, dass** auf dem Trägersubstrat (3) mehrere Kontaktelektroden (5.1, 5.2, 5.3) mit je mindestens einem angelöteten Stift (9.1, 9.2, 9.3) vorgesehen sind, wobei an zwei Kontaktelektroden (5.1, 5.2, 5.3) je ein Widerstandselement (4.1, 4.2) elektrisch anschließt.

8. Leistungswiderstand nach einem der Ansprüche 1 bis 7, **dadurch gekennzeichnet, dass** der als Einpressstift ausgeführte Stift (9.1, 9.2, 9.3) mit seinem Einpresskopf (11.1, 11.2, 11.3) den elektrischen Anschluss (2.1, 2.2, 2.3) ausbildet.

9. Leistungswiderstand nach Anspruch 8, **dadurch gekennzeichnet, dass** der Einpresskopf (11.1, 11.2, 11.3) dem Gehäuse (8) vorsteht.

10. Leistungswiderstand nach einem der Ansprüche 1 bis 9, **dadurch gekennzeichnet, dass** das als Gussform für die Vergussmasse (17) ausgebildete Gehäuse (8) eine erste offene Breitseite (8.3) aufweist.

11. Leistungswiderstand nach einem der Ansprüche 1 bis 10, **dadurch gekennzeichnet, dass** das Trägersubstrat (3) an einer zweiten Breitseite (8.2) des Gehäuses (8) vorgesehen ist.

12. Leistungswiderstand nach einem der Ansprüche 1 bis 11, **dadurch gekennzeichnet, dass** das Widerstandselement (4.1, 4.2) an einem plattenförmigen Trägersubstrat (3) aus einem keramikartigen Material vorgesehen ist.

13. Leistungswiderstand nach einem der Ansprüche 1 bis 12, **dadurch gekennzeichnet, dass** die Vergussmasse (17) mehrschichtig ist, wovon ein erstes Schichtmaterial (17.1) auf Silikonbasis oder aus einem Silikonwerkstoff das Widerstandselement (4.1, 4.2) vergießt und der Stift (9.1, 9.2, 9.3) durch ein zweites Schichtmaterial (17.2) auf Epoxidharzbasis oder auf Polyurethanbasis ragt.

14. Leistungswiderstand nach Anspruch 13, **dadurch gekennzeichnet, dass** das erste Schichtmaterial (17.1) auf Silikonbasis oder aus einem Silikonwerkstoff den Montagekopf (15) des Stifts (9.1, 9.2, 9.3) vergießt.

15. Leistungswiderstand nach Anspruch 13 oder 14, **dadurch gekennzeichnet, dass** das zweite Schichtmaterial (17.2) auf dem ersten Schichtmaterial (17.1) angeordnet ist.

## Claims

1. A power resistor having at least one electrical connection (2.1, 2.2, 2.3), having a carrier substrate (3), which has at least one resistor element (4.1, 4.2) composed of a thick-film material and at least one contact electrode (5.1, 5.2, 5.3) to which the resistor element (4.1, 4.2) electrically connects, having at least one electrical conductor (7.1, 7.2, 7.3), which is soldered to the contact electrode (5.1, 5.2, 5.3) and produces an electrical connection between the contact electrode (5.1, 5.2, 5.3) and the electrical terminal (2.1, 2.2, 2.3), and having a housing (8), which is at least partially filled with at least one casting compound (17) and in which the resistor element (4.1, 4.2) and contact electrode (5.1, 5.2, 5.3) are encapsulated, with the electrical conductor (7.1, 7.2, 7.3) protruding out through the casting compound (17), **characterized in that** a pin, more particularly a soldering pin or press-fitting pin, constitutes the electrical conductor (7.1, 7.2, 7.3), which pin (9.1, 9.2, 9.3) is placed onto the contact electrode (5.1, 5.2, 5.3) and soldered to it and constitutes the electrical terminal (2.1, 2.2, 2.3) of the power resistor (1).

2. The power resistor according to claim 1, **characterized in that** at its first end (10.1, 10.2, 10.3), the pin (9.1, 9.2, 9.3) has a flat end surface (13) that is placed onto the contact electrode (5.1, 5.2, 5.3) and soldered to it.

3. The power resistor according to claim 1 or 2, **characterized in that** at its first end (10.1, 10.2, 10.3), the pin (9.1, 9.2, 9.3) has a protruding mounting head (15).

4. The power resistor according to claim 3, **characterized in that** the mounting head (15) protrudes circumferentially, , more particularly in circular fashion.

5. The power resistor according to claim 3, **characterized in that** the mounting head (15) has at least one soldering foot (18.1, 18.2).

6. The power resistor according to claim 3, 4, or 5, **characterized in that** the mounting head (15) constitutes a flat end surface (13).

7. The power resistor according to one of claims 1 to 6, **characterized in that** a plurality of contact electrodes (5.1, 5.2, 5.3) is provided on the carrier substrate (3), each with at least one soldered-on pin (9.1, 9.2, 9.3), with two contact electrodes (5.1, 5.2, 5.3) being electrically connected to a respective resistor element (4.1, 4.2).

8. The power resistor according to one of claims 1 to 7, **characterized in that** the pin (9.1, 9.2, 9.3), which is embodied as a press-fitting pin, constitutes the electrical terminal (2.1, 2.2, 2.3) with its press-fitting head (11.1, 11.2, 11.3).

9. The power resistor according to claim 8, **characterized in that** the press-fitting head (11.1, 11.2, 11.3) protrudes from the housing (8).

10. The power resistor according to one of claims 1 to 9, **characterized in that** the housing (8) embodied as a mold for the casting compound (17) has a first open broad side (8.3).

11. The power resistor according to one of claims 1 to 10, **characterized in that** the carrier substrate (3) is provided on a second broad side (8.2) of the housing (8).

12. The power resistor according to one of claims 1 to 11, **characterized in that** the resistor element (4.1, 4.2) is provided on a plate-shaped carrier substrate (3) made of a ceramic-like material.

13. The power resistor according to one of claims 1 to 12, **characterized in that** the casting compound (17) is multilayered, a first layer material (17.1) of which is silicone-based or composed of a silicone material and encapsulates the resistor element (4.1, 4.2), and the pin (9.1, 9.2, 9.3) protrudes through a second epoxy resin-based or polyurethane-based layer material (17.2).

14. The power resistor according to claim 13, **characterized in that** the first layer material (17.1), which is silicone-based or composed of a silicone material, encapsulates the mounting head (15) of the pin (9.1, 9.2, 9.3).

15. The power resistor according to claim 13 or 14, **characterized in that** the second layer material (17.2) is positioned on the first layer material (17.1).

## Revendications

1. Résistance de puissance avec au moins un branchement électrique (2.1, 2.2, 2.3), avec un substrat de support (3) qui comporte au moins un élément de résistance (4.1, 4.2) fait d'un matériau en couche épaisse et au moins une électrode de contact (5.1, 5.2, 5.3) à laquelle l'élément de résistance (4.1, 4.2) se connecte électriquement, avec au moins un conducteur électrique (7.1, 7.2, 7.3) qui est brasé avec l'électrode de contact (5.1, 5.2, 5.3) et établit une connexion électrique entre l'électrode de contact (5.1, 5.2, 5.3) et le branchement électrique (2.1, 2.2, 2.3) et avec un boîtier (8) rempli au moins en partie d'une masse d'enrobage (17), qui reçoit l'élément de résistance (4.1, 4.2) et l'électrode de contact (5.1, 5.2, 5.3) dans l'enrobage, le conducteur électrique (7.1, 7.2, 7.3) dépassant à travers la masse d'enrobage (17), **caractérisée en ce qu'**une broche, en particulier une broche à braser ou à enficher, forme le conducteur électrique (7.1, 7.2, 7.3), laquelle broche (9.1, 9.2, 9.3) est posée sur l'électrode de contact (5.1, 5.2, 5.3) et brasée avec celle-ci et forme le branchement électrique (2.1, 2.2, 2.3) de la résistance de puissance (1).

2. Résistance de puissance selon la revendication 1, **caractérisée en ce que** la broche (9.1, 9.2, 9.3) présente à sa première extrémité (10.1, 10.2, 10.3) une face d'extrémité plane (13) qui est posée sur l'électrode de contact (5.1, 5.2, 5.3) et brasée avec celle-ci.

3. Résistance de puissance selon la revendication 1 ou 2, **caractérisée en ce que** la broche (9.1, 9.2, 9.3) présente à sa première extrémité (10.1, 10.2, 10.3) une tête de montage (15) évasée.

4. Résistance de puissance selon la revendication 3, **caractérisée en ce que** la tête de montage (15) est évasée sur sa circonférence, en particulier de façon circulaire.

5. Résistance de puissance selon la revendication 3, **caractérisée en ce que** la tête de montage (15) comporte au moins un pied de brasage (18.1, 18.2).

6. Résistance de puissance selon la revendication 3, 4 ou 5, **caractérisée en ce que** la tête de montage (15) présente une face d'extrémité (13) plane.

7. Résistance de puissance selon l'une des revendications 1 à 6, **caractérisée en ce que** plusieurs électrodes de contact (5.1, 5.2, 5.3) avec au moins une broche (9.1, 9.2, 9.3) brasée sur chacune sont prévues sur le substrat de support (3), un élément de résistance (4.1, 4.2) étant connecté électriquement à chacune des deux électrodes de contact (5.1, 5.2, 5.3).

8. Résistance de puissance selon l'une des revendications 1 à 7, **caractérisée en ce que** la broche (9.1, 9.2, 9.3) réalisée corne une broche à enficher forme le branchement électrique (2.1, 2.2, 2.3) avec sa tête d'enfichage (11.1, 11.2, 11.3).

9. Résistance de puissance selon la revendication 8, **caractérisée en ce que** la tête d'enfichage (11.1, 11.2, 11.3) dépasse du boîtier (8).

10. Résistance de puissance selon l'une des revendications 1 à 9, **caractérisée en ce que** le boîtier (8) conformé comme un moule de coulée pour la masse d'enrobage (17) présente un premier côté large (8.3) ouvert.

11. Résistance de puissance selon l'une des revendications 1 à 10, **caractérisée en ce que** le substrat de support (3) est prévu sur un deuxième côté large (8.2) du boîtier (8).

12. Résistance de puissance selon l'une des revendications 1 à 11, **caractérisée en ce que** l'élément de résistance (4.1, 4.2) est prévu sur un substrat de support (3) en forme de plaque fait d'un matériau de type céramique.

13. Résistance de puissance selon l'une des revendications 1 à 12, **caractérisée en ce que** la masse d'enrobage (17) comporte plusieurs couches, un premier matériau de couche (17.1) à base de silicone ou d'un matériau siliconé enrobant l'élément de résistance (4.1, 4.2) et la broche (9.1, 9.2, 9.3) dépassant à travers un deuxième matériau de couche (17.2) à base de résine époxy ou à base de polyuréthane.

14. Résistance de puissance selon la revendication 13, **caractérisée en ce que** le premier matériau de couche (17.1) à base de silicone ou d'un matériau siliconé enrobe la tête de montage (15) de la broche (9.1, 9.2, 9.3).

15. Résistance de puissance selon la revendication 13 ou 14, **caractérisée en ce que** le deuxième matériau de couche (17.2) est disposé sur le premier matériau de couche (17.1).
